# EUROPEAN PATENT APPLICATION

(11) **EP 3 772 144 A1**
(43) Date of publication of application: **03.02.2021**
(21) Application number: 20187316.3
(22) Date of filing: 23.07.2020
(51) Int. Cl.: H01R 43/28, H01R 9/05

(54) **INTERMEDIATE PRODUCT AND METHOD FOR CRIMPING AN ELECTRICAL CONDUCTOR**

(30) Priority: 31.07.2019 DE 102019211473
(71) Applicant: TE Connectivity Germany GmbH, 64625 Bensheim (DE)
(72) Inventor: DE CLOET, Olivier, 64653 Lorsch (DE); SCHRETTLINGER, Christian, 64625 Bensheim-Auerbach (DE)
(74) Representative: Grünecker Patent- und Rechtsanwälte PartG mbB

(57) **Abstract**

The invention relates to an intermediate product (1) for crimping, having an electrical conductor (2), in particular a network cable (4), which has a shielding braid (6) and extends along a longitudinal axis (L), and having an insulation (8) which at least partially encloses the shielding braid (6), wherein the shielding braid (6) has, in a region (10) along the longitudinal axis (L), a radially compressed core in comparison to the immediate surroundings along the longitudinal axis (L). Furthermore, the invention relates to a method for crimping an electrical conductor (2), wherein, before the crimping, a region (10) of the electrical conductor (2), which extends along the longitudinal axis (L), is compacted. As a result of the precompacting, the electrical conductor (2) can be compressed to a predetermined diameter (12) in the region (10), with the result that the quality of the crimping process is improved and manufacturing errors can be avoided.

## Description

The invention relates to an intermediate product for crimping and to a method for crimping an electrical conductor.

In order to terminate an electrical conductor, contacts with a crimp connection, for example a crimp sleeve, are laid around the electrical conductor and compressed with the crimp connection. As a result, a mechanically and electrically stable connection is produced between the contact and the conductor. The electrical conductors are manufactured with a certain tolerance, which results in irregularities arising in the diameter of the conductor. Furthermore, electrical conductors with slight differences in diameter can be found on the market. In particular in the case of crimping, in practice this leads to waste, for example if single strands of a shielding braid protrude radially out of the crimp seam of an e.g. slotted, open crimp sleeve, such that this results in an excessively high degree of waste during production of a crimped conductor.

The problem of the invention is therefore to provide an intermediate product for crimping, which reduces the risk of manufacturing errors during crimping.

The problem is solved according to the invention by an intermediate product for crimping, having an electrical conductor, in particular a network cable, which extends along a longitudinal axis, having a shielding braid and having an insulation which encloses the shielding braid, wherein the electrical conductor has, in a region along the longitudinal axis, a radially compressed core in comparison to the immediate surroundings along the longitudinal axis.

Furthermore, the problem is solved by a method for crimping an electrical conductor, in particular a network cable, which extends along a longitudinal axis, having a shielding braid and an insulation which encloses the electrical conductor, comprising the step of compacting a region of the electrical conductor, which extends along the longitudinal axis, in the radial direction before the crimping.

A region with a radially compressed core is created by the compacting. The compressed core can have a predefined diameter, wherein the irregularities in the diameter of the electrical line are eliminated in the region with the radially compressed core. As a result, the crimp sleeve can be laid around this region and be crimped with the conductor, without the individual stands projecting radially out of the crimp seam. Consequently, the production of waste product on account of faulty crimping is reduced or even prevented. Furthermore, different electrical conductors with slight differences in diameter can be standardised at least in that region, so that structurally identical crimp sleeves can be attached in the regions of the different conductors. As a result, the variety of components is reduced, resulting in further cost savings. Small requirements of a special line can potentially be crimped with existing components, in particular crimp sleeves.

Hereinafter, further developments are specified which can be combined with one another as desired, independently of one another, and are each themselves advantageous per se.

Thus, for example, the region with the radially compressed core can be arranged at a free end of the electrical conductor. As a result, the crimp sleeve in the region with the radially compressed core can be pushed up slightly and crimped with this region.

The region with the radially compressed core can be spaced apart from the free end of the electrical conductor along the longitudinal axis, preferably at most by the length of a crimp sleeve which is standardised in particular for network cables having a standardised diameter. As a result, the section of the shielding braid between the region with the radially compressed core and the free end can be bent back over the crimp sleeve, without the shielding braid projecting over the region away along the longitudinal axis.

According to a further advantageous configuration, the length of the region with the radially compressed core can correspond at least to the length of a crimp sleeve which is standardised for the conductor diameter. Thus the region with the radially compressed core offers a seat for the crimp sleeve, wherein, in the region, the diameter of the electrical conductor is predetermined by the compacting.

In particular, the region with the radially compressed core can be arranged at a spacing of approximately 2 mm to approximately 4 mm from the free end in the longitudinal axis.

In a further advantageous configuration, the region with the compressed core can taper off conically along the longitudinal axis at one end of the region. As a result, for example, a build-up of the insulation material at the end of the region along the longitudinal axis can be prevented.

Preferably, the region with the compressed core can taper off conically at both ends of the region along the longitudinal axis, with the result that a build-up of the insulation material at both ends of the region, for example as a result of a stepwise decrease in the diameter of the electrical conductor, can be prevented.

According to a further advantageous configuration, the electrical conductor can be free from the insulation at least at the region with the radially compressed core. Therefore, in this region, the crimp sleeve can be applied to the electrical conductor, in particular to the shielding braid, and crimped therewith.

The shielding braid can in particular be an outer conductor and be formed from stranded wires, for example, in which the individual wires can be compressed to the most precise and completely monitored final dimensions by the compacting. As a result, the processed electrical conductors do not have any protruding stranded wires or any burrs, and the crimp sleeve can be crimped around the region with the radially compressed core.

The region with the radially compressed core can be compacted after the stripping. As a result, it is possible to prevent parts of the insulation from getting caught in the shielding braid during the stripping. However, the region with the radially compressed core can preferably be compacted first, before it is stripped. Therefore the insulation can serve as a protective sheath during the compacting and can prevent individual strands of the shielding braid from being damaged.

The region with the radially compressed core can be compacted by ultrasound welding, for example. In particular during the ultrasound welding, an inherently homogeneous core with the smallest possible contact resistance can be created. As an alternative to this, the core can also be compressed by compressing radially to a specified diameter.

According to a further advantageous configuration, after the crimping of the crimp sleeve in the radially compressed region, the shielding braid can be bent back around the crimp sleeve from the free end of the electrical conductor which protrudes along the longitudinal axis, wherein the bent-back part does not protrude from the shielding braid along the longitudinal axis over the end of the crimp sleeve facing away from the free end of the electrical conductor.

The crimp sleeve can in particular be a support sleeve, wherein a predetermined section from the shielding braid is turned over the support sleeve, such that the shielding braid surrounds the support sleeve at least partially radially from the outside. The section can be crimped by means of an outer sleeve between the support sleeve and the outer sleeve. Preferably, the inner conductor can be free before the crimping of the outer sleeve and crimped with an inner conductor sleeve. The outer sleeve can be configured in such a way that it extends away along the longitudinal axis over the inner conductor sleeve and surrounds it radially.

Hereinafter, the invention is described in greater detail by way of example using exemplary embodiments with reference to the attached figures. In the figures, elements which correspond to one another in design and/or function are provided with the same reference numerals.

The combination of features shown and described with the individual exemplary embodiments serves solely the purposes of explanation. In accordance with the statements above, it is possible to dispense with a feature from an exemplary embodiment if its technical effect is of no importance in a particular application. Conversely, according to the above statements, a further feature can be added to an exemplary embodiment if its technical effect is meant to be advantageous or necessary for a particular application.

In the figures:
- Fig. 1: shows a schematic perspective view of an intermediate product according to the invention;
- Fig. 2: shows a schematic sectional view of the intermediate product depicted in Fig. 1 after the crimping.

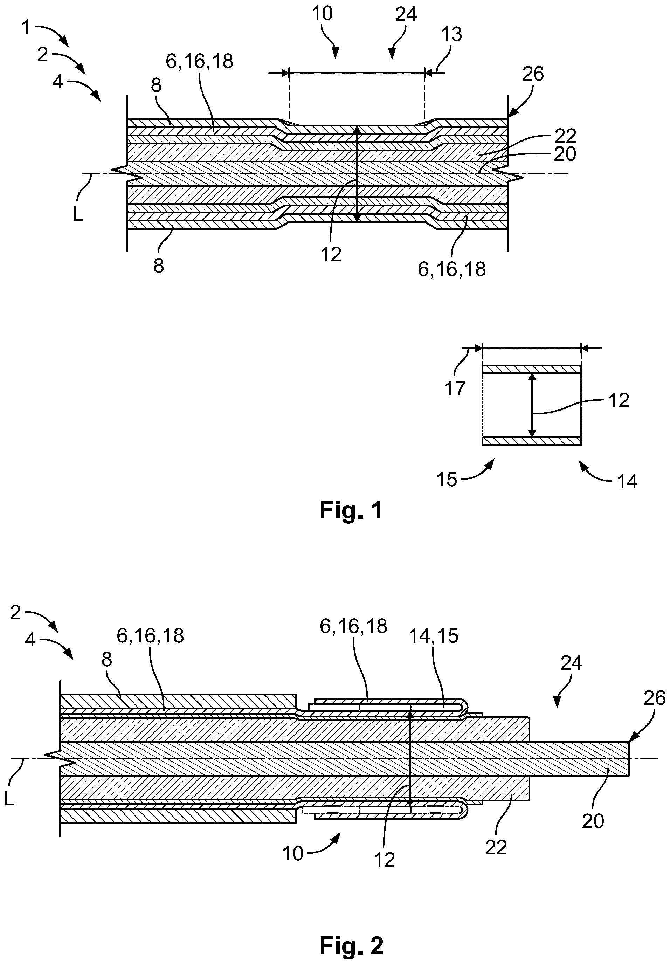

First of all, an exemplary configuration of an intermediate product 1, according to the invention, for crimping is explained is greater detail with reference to Fig. 1.

The intermediate product 1 comprises an electrical conductor 2, which extends along a longitudinal axis L. The electrical conductor 2 can preferably be a standardised network cable 4. The electrical conductor 2 has a shielding braid 6 and an insulation 8 radially surrounding the shielding braid 6. In a region 10 along the longitudinal axis L, the electrical conductor 2 is radially compressed to a predetermined diameter 12, so that a crimp sleeve 14 can be placed onto the electrical conductor 2 in this region 10 and can be crimped therewith. By compacting the electrical conductor 2 in the region 10, the conductor can be reduced radially to the predetermined diameter and in particular unified, so that individual strands of the shielding braid 6 do not protrude radially out of the crimp sleeve 14 during crimping.

Preferably, at least the region 10 with the radial compression can be free from the insulation 8, as depicted in Fig. 2, so that the crimp sleeve 14 can be laid directly onto the shielding braid 6. The insulation 8 can be removed from the region 10 in particular after the compacting, so that the insulation 8 serves as a protective sheath during the compacting and the individual strands of the shielding braid 6 are not damaged.

In particular, the shielding braid 6 can be compressed to the predefined diameter 12, since the crimp sleeve 14 is laid around the shielding braid 6 during the crimping and is crimped therewith.

The region 10 can be compressed by ultrasound welding, for example. As an alternative to this or also in addition, the region 10 can also be radially reduced to the predefined diameter 12 by compressing the individual strands.

The shielding braid 6 can be an outer conductor 16, which is formed from stranded wires 18. During manufacture of the electrical conductor 2, the adjustment to the predefined diameter 12 can be made more difficult in particular on account of the shielding braid 6. In the case of the shielding braid 6, irregularities and high tolerances frequently occur during production, which can lead to problems during the crimping, however, since individual strands, in particular stranded wire cores, can protrude radially out of the crimp sleeve 14.

The electrical conductor 2 can preferably have at least one inner conductor 20, which can be arranged centrally in the electrical conductor 2 and is surrounded radially by a dielectric 22. A shielding foil 24 can be arranged between the dielectric 22 and the shielding braid 6 to protect the inner conductor 20 from static magnets and/or magnetic alternating fields.

The region 10 can be arranged at a free end 24 of the electrical conductor 2 along the longitudinal axis L. Preferably the region 10 can be spaced apart from a termination 26 at the free end 24 of the electrical conductor 2 along the longitudinal axis L. The region 10 can be spaced apart from the termination 26 along the longitudinal axis L, preferably at most by the length of a crimp sleeve 14, in particular a support sleeve 15, which is standardised for network cables. As a result, the shielding braid 6 can be prevented from protruding from the crimp sleeve 14 when it is turned over the crimp sleeve 14 on the side of the crimp sleeve 14 facing away from the termination 26.

The length 13 of the region 10 along the longitudinal axis L can preferably correspond at least to the length 17 of a standardised crimp sleeve 14 for network cables. As a result of the radial compression in the region 10, a seat can be created for the crimp sleeve 14, which seat prevents the crimp sleeve 14 from sliding along the longitudinal axis L relative to the region 10. This leads to a further facilitation of the crimping procedure.

Preferably, the region 10 can taper off conically at at least one end of the region 10 along the longitudinal axis L, in particular at both ends of the region 10. As a result, a build-up of material during the stripping at the respective ends of the region 10 can be prevented. The insulation 8 can be stripped off more easily and a stepwise crossover, in which the insulation 8 can get caught, does not form.

The free inner conductor 20 can be crimped with an inner conductor sleeve, before an outer sleeve is crimped with the support sleeve 15 and clamps the section of the shielding braid 6, which is turned over the support sleeve 15, between support sleeve 15 and outer sleeve.

As a result of the intermediate product according to the invention and the method according to the invention, errors during manufacture of crimped electrical conductors 2 can be reduced or even prevented. The electrical conductor 2, in particular the shielding braid 6, can be compressed to a substantially uniform and predefined diameter 12 in the region 10 by precompacting, wherein the diameter 12 can be adapted to the respective requirements of the crimp sleeve 14. Furthermore, as a result of the solution according to the invention, a variety of electrical conductors 2 with small differences in diameter can be standardised at least in the region 10, with the result that different electrical conductors 2 can be coupled to identically structured components, for example crimp sleeves 14. The enables a reduction in different components, resulting in further cost savings.

### Reference numerals

- 1: intermediate product
- 2: electrical conductor
- 4: network cable
- 6: shielding braid
- 8: insulation
- 10: region
- 12: predetermined diameter
- 13: length of the region
- 14: crimp sleeve
- 15: support sleeve
- 16: outer conductor
- 17: length of a crimp sleeve
- 18: stranded wires
- 20: inner conductor
- 22: dielectric
- 24: free end
- 26: termination

## Claims

1. An intermediate product (1) for crimping, having an electrical conductor (2), in particular having a network cable (4), comprising the electrical conductor (2), which extends along a longitudinal axis (L), having a shielding braid (6) and having an insulation (8) which at least partially encloses the shielding braid (6), wherein the electrical conductor (2) has, in a region (10) along the longitudinal axis (L), a radially compressed core in comparison to the immediate surroundings along the longitudinal axis (L).

2. The intermediate product (1) according to Claim 1, wherein the region (10) with the radially compressed core is formed at a free end (24) of the electrical conductor (2).

3. The intermediate product (1) according to Claim 1 or 2, wherein the region (10) with the radially compressed core tapers off conically at at least one end of the region (10) along the longitudinal axis (L).

4. The intermediate product (1) according to Claim 3, wherein the region (10) with the radially compressed core tapers off conically at both ends of the region (10) along the longitudinal axis (L).

5. The intermediate product (1) according to any one of Claims 1 to 4, wherein the shielding braid (6) is free from the insulation (8) at least in the region (10) with the radially compressed core.

6. The intermediate product (1) according to any one of Claims 1 to 5, wherein the length of the region (10) with the compressed core corresponds at least to the length of a support sleeve (15) along the longitudinal axis (L), which support sleeve (15) is standardised for a predetermined diameter of an electrical conductor (2).

7. A method for crimping an electrical conductor (2), in particular a network cable (4), having a shielding braid (6), which extends along a longitudinal axis (L), and having an insulation (8) which encloses the shielding braid (6), comprising the following step:
- compacting a region (10) of the electrical conductor (2), which extends along the longitudinal axis (L), in the radial direction before the crimping.

8. The method according to Claim 7, wherein at least the region (10) is stripped after the compacting.

9. The method according to Claim 7 or 8, wherein the region (10) is compacted by ultrasound welding.

10. The method according to Claim 7 or 8, wherein the region (10) is compacted by pressing.
